# EUROPEAN PATENT APPLICATION

(11) **EP 4 670 996 A1**
(43) Date of publication of application: **31.12.2025**
(21) Application number: 25185181.2
(22) Date of filing: 25.06.2025
(51) Int. Cl.: B41J 29/393, G06F 1/00, G03G 19/00

(54) **PRINTER**

(30) Priority: 28.06.2024 JP 2024104945; 28.04.2025 JP 2025074055
(71) Applicant: BROTHER KOGYO KABUSHIKI KAISHA, Aichi-ken 467-8561 (JP)
(72) Inventor: SAKAI, Naoya, Nagoya, 467-8562 (JP)
(74) Representative: Kuhnen & Wacker Patent- und Rechtsanwaltsbüro PartG mbB

(57) **Abstract**

A printer (1) is adapted to perform printing on a medium. The printer (1) includes a printing unit (3), a power supply circuit (100A, 100B, 100C), and a controller (21). The printing unit (3) is disposed inside a printer. The power supply circuit (100A, 100B, 100C) is disposed inside the printer, and includes a power supply line and a power storage device. The power supply line is adapted to supply power from a power supply (8, 15, 17) to the printing unit (3). The power storage device is adapted to charge and discharge a predetermined power. The controller (21) is adapted to perform connecting processing to connect the power storage device in series with the power supply (8, 15, 17) in the power supply line, by controlling the power supply circuit (100A, 100B, 100C).

## Description

### BACKGROUND ART

The present invention relates to a printer.

A printer disclosed in Japanese Laid-Open Patent Publication No. 2023-80510 is driven by electric power supplied via a USB is known. For example, the printer is driven by power supplied through a USB PD and performs printing on a medium.

### SUMMARY OF INVENTION

In the above-described printer, if the power supplied via the USB is insufficient, there is a possibility that printing by the printer may be restricted.

An object of the present invention is to provide a printer that contributes to reducing the likelihood of printing being restricted even when the power supplied from the power supply is insufficient.

A printer according to the present invention is adapted to perform printing on a medium. The printer includes a printing unit, a power supply circuit, and a controller. The printing unit is disposed inside the printer. The power supply circuit is disposed inside the printer. The power supply circuit includes a power supply line and a power storage device. The power supply line is adapted to supply power from a power supply to the printing unit. The power storage device is adapted to charge and discharge a predetermined power. The controller is adapted to perform connecting processing to connect the power storage device in series with the power supply in the power supply line, by controlling the power supply circuit.

Since the printer connects the power storage device in series with the power supply, the power supply circuit supplies power to the printing unit by supplementing power from the power storage device to the power from the power supply. Therefore, the printer contributes reducing the likelihood of printing being restricted under a circumstance where the power supplied from the power supply is insufficient.

In the printer, the controller is further adapted to perform disconnecting processing to disconnect the power storage device from the power supply line. The controller is further adapted to perform grounding processing to connect the power storage device between the power supply and a ground. The controller is further adapted to perform setting processing to set a mode of the power supply circuit to one mode among a first mode, a second mode, and a third mode. The first mode is a mode to supply power from the power supply to the printer unit by performing the disconnecting processing. The second mode is a mode to supply, to the printing unit, supplementary power in which the power from the power supply is supplemented by the power from the power storage device by performing the connecting processing. The third mode is a mode to charge the power storage device by performing the grounding processing. The printer contributes to performing printing by providing supplementary power under a circumstance where the power supplied from the power supply is insufficient. Furthermore, the printer contributes to performing printing using only power from the power supply under a circumstance where the power is sufficiently large, for example. The printer contributes to preparing for printing by charging the power storage device under a circumstance where the power from the power supply is low. In other words, the printer contributes to setting to one mode among the first to third modes according to the power of the power supply.

In the printer, the controller is adapted to perform, in the setting processing first setting processing to set the power supply circuit to the first mode based on determining that power from the power supply is equal to or greater than a predetermined value. The controller is further adapted to perform second setting processing to set the power supply circuit to the third mode based on determining that the power from the power supply is less than the predetermined value. The printer contributes to performing printing using only power from the power supply under a circumstance where the power from the power supply is sufficiently large, for example. The printer contributes to preparing for printing by charging the power storage device under a circumstance where the power from the power supply is less than the predetermined value.

In the printer, the controller is adapted to perform, in the setting processing, third setting processing to set the power supply circuit from the third mode to the second mode based on receiving a print command causing the printing unit to print onto the medium, while the power supply circuit is in a state set to the third mode by the second setting processing. The controller is adapted to perform, in the setting processing, detection processing to detect a voltage supplied to the printing unit while the power supply circuit is in a state set to the second mode in the third setting processing. The controller is adapted to perform, in the setting processing, first printing processing to cause, in a state in which the power supply circuit is set to the second mode, the printing unit to perform printing onto the medium based on the supplementary power, based on determining that the voltage detected in the detection processing is equal to or greater than a threshold value. The controller is adapted to perform, in the setting processing, fourth setting processing to, based on determining that the voltage detected in the detection processing is less than the threshold value, set the power supply circuit to the third mode without causing the printing unit to perform printing onto the medium. Under a circumstance where the power from the power supply is insufficient, the printer contributes to performing printing with the printing unit based on supplementary power. Further, the printer contributes to performing charging of the power storage device to compensate for any deficiency in supplementary power under a circumstance where supplementary power is insufficient based on the relationship between the detected voltage and the threshold value.

In the printer, the controller is adapted to perform notification processing to provide notification based on determining that the power supply circuit is set to the third mode in the fourth setting processing. The printer, for example, contributes to notifying the user of the necessity to wait until the power storage device is sufficiently charged before commencing printing.

In the printer, the controller is adapted to further perform receiving processing to receive a command to forcibly perform printing by the printing unit. The controller is adapted to perform fifth setting processing to, in the setting process, set the power supply circuit from the third mode set in the fourth setting processing to the first mode, based on determining that the command is received in the receiving processing. The controller is adapted to further perform second printing processing to perform printing onto the medium by the printing unit with the power supply circuit set to the first mode in the fifth setting processing. The printer contributes to performing printing using the power from the power supply by, for example, slowing down the printing speed.

In the printer, the print command includes information about the number of sheets to be continuously printed in a case where printing is to be performed continuously. The controller is adapted to perform, in the setting processing, the fourth setting processing based on determining that the number of sheets to be continuously printed is equal to or greater than a predetermined number of sheets. Under a circumstance where the printer is subjected to a heavy printing load, such as when a large number of sheets are to be continuously printed, the printer charges the power storage device without performing printing. The printer contributes to avoiding operation under overload conditions.

In the printer, the controller is adapted to perform, in the setting process, third setting processing to set the power supply circuit from the third mode to the second mode based on determining that a print command causing the printing unit to print onto the medium is received, while the power supply circuit is in a state set to the third mode in the second setting processing; detection processing to detect a voltage supplied to the printing unit while the power supply circuit is set to the second mode in the third setting processing. The controller is adapted to perform, in the setting process first printing processing to perform, in a state in which the power supply circuit is set to the second mode and causing the printing unit, printing onto the medium based on the supplementary power, based on determining that the voltage detected in the detection processing is equal to or greater than a threshold value. The controller is adapted to perform, in the setting process, sixth setting processing to, based on determining that the voltage detected in the detection processing is less than the threshold value, set the power supply circuit from the second mode set in the third setting processing to the first mode. The controller is adapted to perform, in the setting process, second printing processing to perform printing onto the medium by the printing unit, while the power supply circuit is in a state set to the first mode in the sixth setting processing. Under a circumstance where the power supply is insufficient, the printer contributes to causing the printing unit to perform printing based on supplementary power. Moreover, the printer contributes to performing printing on the medium by reducing the printing speed or the like under a circumstance where supplementary power is insufficient based on the relationship between the detected voltage and the threshold value.

In the printer, the print command includes information about the number of sheets to be continuously printed in a case where printing is to be performed continuously. The controller is adapted to perform the second printing processing based on determining that the number of sheets to be continuously printed is less than a predetermined number of sheets. The printer also contributes to performing printing by reducing the printing speed or the like under a circumstance where the printing load is light, such as a case where there is a small number of sheets to be continuously printed.

In the printer, the controller is adapted to perform, in the setting processing, seventh setting processing to set the power supply circuit to the third mode based on determining that the printing onto the medium by the printing unit is completed. The printer contributes to resuming charging of the power storage device after the time printing on the medium is completed.

In the printer, the power storage device is in an open state in the first mode. In the first mode, the printer does not perform charging or discharging of the power storage device. Therefore, the printer contributes to reducing the number of charging and discharging cycles of the power storage device. Consequently, the printer contributes to suppressing the degradation of the power storage device.

In the printer, the power storage device is an electric double-layer capacitor. By using an electric double-layer capacitor, the printer contributes to achieving rapid charging.

In the printer, the power storage device is a lithium-ion battery. By using a lithium-ion battery, the printer contributes to supplementing the power over an extended period of time.

In the printer, the power supply is a USB power supply. The printer contributes to reducing the likelihood that printing will be restricted under a circumstance where the power from the USB power supply is insufficient.

In the printer, the power supply is an AC adapter or a battery. The printer contributes to reducing the likelihood that printing will be restricted under a circumstance where the power from the AC adapter or the battery is insufficient.

### BRIEF DESCRIPTION OF DRAWINGS

Embodiments will be described below in detail with reference to the accompanying drawings in which:
FIG. 1 is a diagram showing an electrical configuration of a printer 1;
FIG. 2 is a diagram showing a power supply circuit 100A;
FIG. 3 is a diagram showing a first mode of the power supply circuit 100A;
FIG. 4 is a diagram showing a second mode of the power supply circuit 100A;
FIG. 5 is a diagram showing a third mode of the power supply circuit 100A;
FIG. 6 is a flowchart of main processing;
FIG. 7 is a flowchart of first processing;
FIG. 8 is a flowchart of second processing;
FIG. 9 is a chart showing printing conditions;
FIG. 10 is a diagram showing a power supply circuit 100B according to a modified example;
FIG. 11 is a diagram showing a first mode of the power supply circuit 100B;
FIG. 12 is a diagram showing a second mode of the power supply circuit 100B;
FIG. 13 is a diagram showing a third mode of the power supply circuit 100B;
FIG. 14 is a diagram showing a power supply circuit 100C according to a modified example;
FIG. 15 is a diagram showing a first mode of the power supply circuit 100C;
FIG. 16 is a diagram showing a second mode of the power supply circuit 100C; and
FIG. 17 is a diagram showing a third mode of the power supply circuit 100C;

### Description of Embodiments

A printer 1 according to one embodiment of the present invention will be described with reference to the drawings. The printer 1 is driven by power from a USB power supply 8, for example. The USB power supply 8 corresponds to a USB Power Delivery (USB PD). The printer 1 prints an image on a medium based on a print command. The medium is not limited to a specific type, and may be sheet-like or tape-like, for example. In this embodiment, the medium is thermal cut sheet paper.

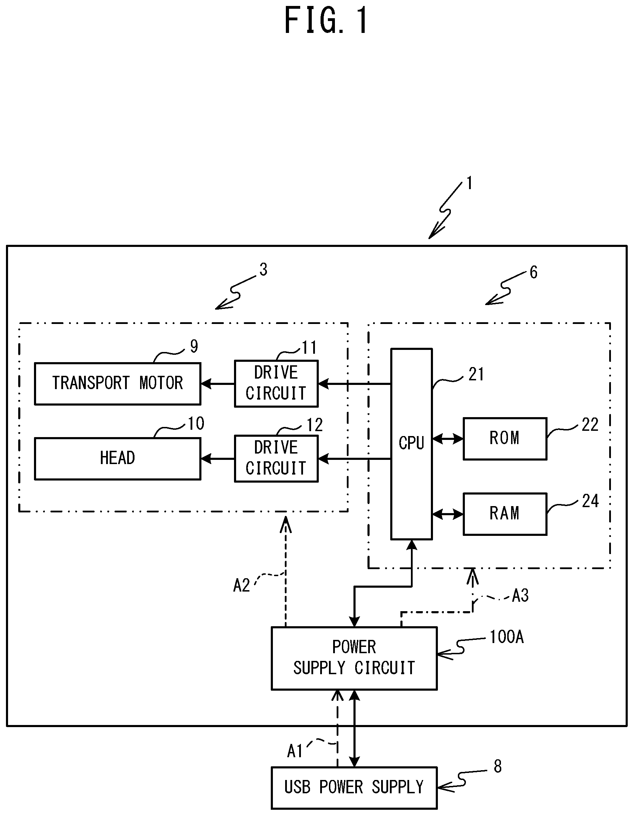

The electrical configuration of the printer 1 will be described with reference to FIG. 1. The printer 1 includes a power supply circuit 100A, a digital circuit 6, and a printing unit 3. The power supply circuit 100A supplies power (arrow A1) from the USB power supply 8 to both the printing unit 3 and the digital circuit 6 (refer to arrows A2 and A3).

The digital circuit 6 includes a CPU 21, ROM 22, and RAM 24. The CPU 21 performs overall control of the printer 1. The CPU 21 is electrically connected to the ROM 22 and the RAM 24, and drive circuits 11 and 12. Various programs necessary for controlling the printer 1 are stored in the ROM22. The CPU 21 performs various operations based on these programs. Various operation data is stored in the RAM 24.

The printing unit 3 performs printing on the medium. The printing unit 3 includes the drive circuits 11 and 12, a transport motor 9, and a thermal head (hereinafter referred to as "head 10"). The drive circuits 11 and 12 are electrically connected to the CPU 21. The drive circuit 11 is connected to the transport motor 9. The transport motor 9 generates the power necessary to transport the medium. The transport motor 9 transports the medium by the driving of the drive circuit 11.

The drive circuit 12 is connected to the head 10. The head 10 is disposed inside the printer 1. The head 10 performs printing on the medium based on a print command. The head 10 includes a plurality of heating elements. The head 10 selectively heats the plurality of heating elements by the driving of the drive circuit 12. The CPU 21 performs printing on the medium by driving the transport motor 9 and the head 10 via the drive circuits 11 and 12.

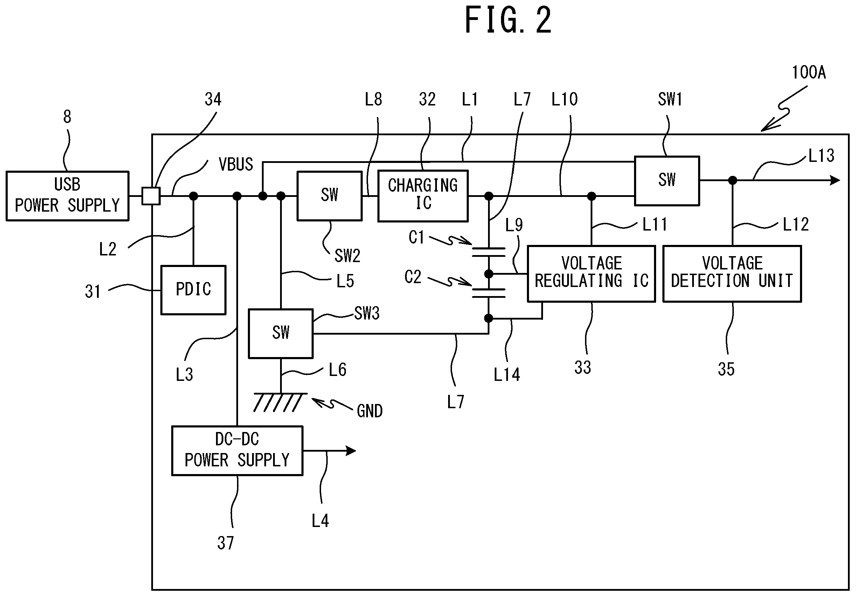

The power supply circuit 100A will be described with reference to FIG. 2. The power supply circuit 100A includes a port 34, a PDIC 31, a charging IC 32, power storage devices C1 and C2, a voltage regulating IC 33, a voltage detection unit 35, a DC-DC power supply 37, switches SW1 to SW3, and wirings VBUS and L1 to L14, and the like.

The port 34, for example, is a USB interface in compliance with the Type-C standard. A USB terminal of the USB power supply 8 is connected to the port 34. The PDIC 31 is connected to the port 34 via the wirings VBUS and L2. The PDIC 31 negotiates with the USB power supply 8 and controls the power from the USB power supply 8. The DC-DC power supply 37 is connected to the port 34 via the wirings L3 and VBUS. The DC-DC power supply 37 provides power to the digital circuit 6 via the wiring L4.

The switches SW1 to SW3 are electronic devices capable of being turned on and off, such as transistors. The switch SW1 is connected to the port 34 via the wirings L1 and VBUS. Furthermore, the switch SW1 is connected to the printing unit 3 via the wiring L13. The switch SW1 switches the connection of the wirings L1, L10, and L13.

The switch SW2 is connected to the port 34 via the wiring VBUS. The switch SW2 switches the connection of the wirings VBUS and L8. The switch SW3 is connected to the port 34 via the wirings L5 and VBUS. Furthermore, the switch SW3 is connected to a ground GND via the wiring L6. The switch SW3 switches the connection of the wirings L5 to L7.

The charging IC 32 is connected to the switch SW2 via the wiring L8. Also, the charging IC 32 is connected to the switch SW1 via the wiring L10. Additionally, the charging IC 32 is connected to the power storage devices C1 and C2 via the wirings L10 and L7. The charging IC 32 charges the power storage devices C1 and C2 with power from the USB power supply 8. The details will be described later.

The power storage devices C1 and C2 are, for example, electric double-layer capacitors. The power storage devices C1 and C2 charge and discharge a predetermined power. The capacitance of the power storage devices C1 and C2 is the same, for example. One end of the power storage device C1 is connected to the switch SW1 and the charging IC 32 via the wirings L7 and L10. The other end of the power storage device C1 is connected to one end of the power storage device C2. The other end of the power storage device C2 is connected to the switch SW3 via the wiring L7. In other words, in the wiring L7, the power storage devices C1 and C2 are connected in series.

The voltage regulating IC 33 is connected to the charging IC 32 and switch SW1 via the wirings L10 and L11. Also, the voltage regulating IC 33 is connected to one end of the power storage device C1 via the wirings L11, L10, and L7. The voltage regulating IC 33 is connected to the connection between the power storage devices C1 and C2 via the wiring L9. The voltage regulating IC 33 is also connected to the other end of the power storage device C2 via the wirings L14 and L7. The voltage regulating IC 33 evenly regulates the respective output voltages of the power storage devices C1 and C2.

The voltage detection unit 35 is connected to the switch SW1 and the printing unit 3 via the wirings L12 and L13. The voltage detection unit 35 is, for example, an analog-to-digital converter. The voltage detection unit 35 detects the voltage value output to the printing unit 3. The voltage detection unit 35 transmits the detected result of the voltage value to the digital circuit 6.

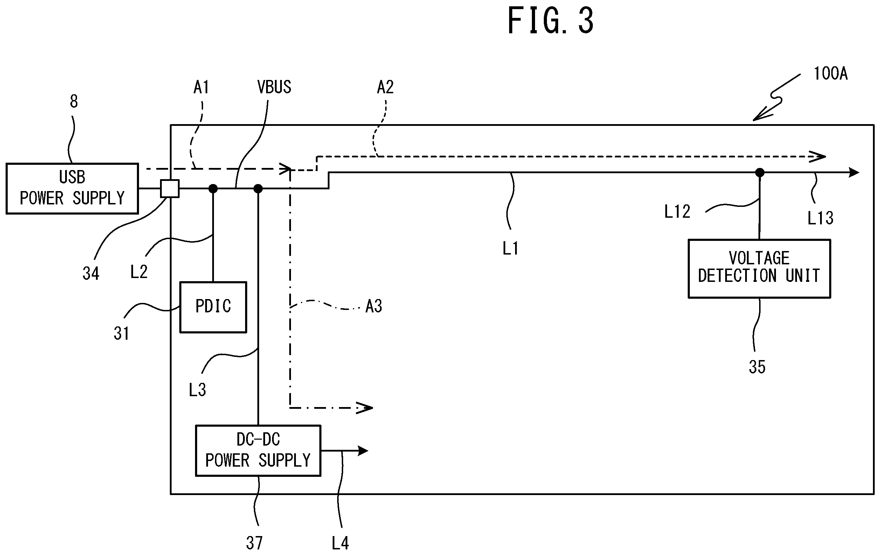

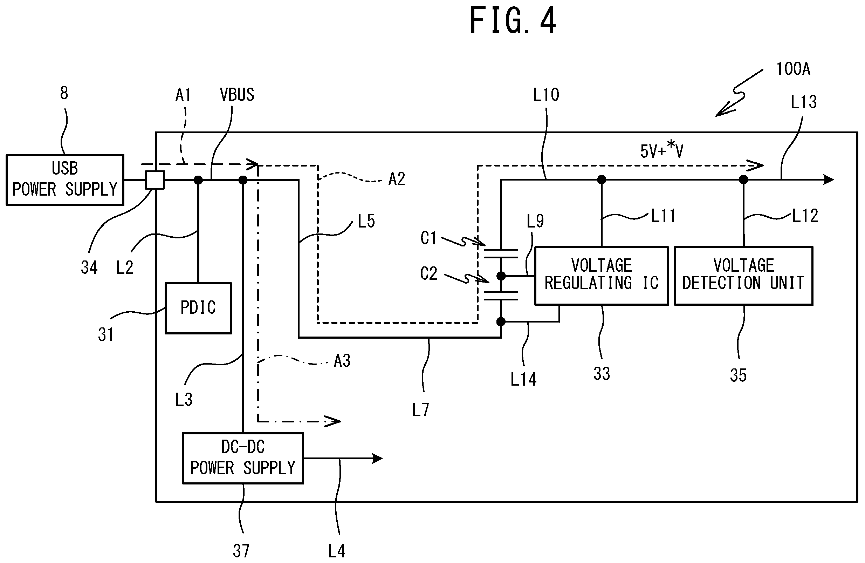

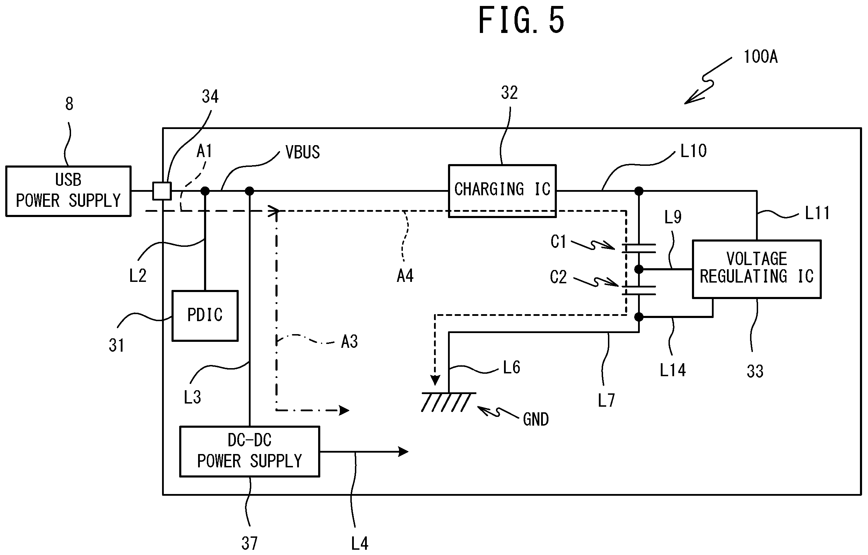

The power supply circuit 100A is set to one of three modes: a first mode (refer to FIG. 3), a second mode (refer to FIG. 4), or a third mode (refer to FIG. 5). The switching between the first mode, the second mode, and the third mode is achieved by changing the states of the switches SW1 to SW3. The switches SW1 to SW3 are controlled by the CPU 21.

The first mode will be described with reference to FIG. 3. In the first mode, power from the USB power supply 8 is supplied to the printing unit 3 (refer to arrow A2). In the first mode, the switch SW1 turns on the connection of the wirings L1 and L13. The switch SW2 turns off the connection of the wirings VBUS and L8, while the switch SW3 turns off the connection of the wirings L5 to L7. As a result, the port 34 and the printing unit 3 are connected via the wirings VBUS, L1, and L13. Therefore, the power supply circuit 100A contributes to supplying power directly from the USB power supply 8 to the printing unit 3. Thus, in the first mode, the wirings VBUS, L1, and L13 function as a "power supply line". The power supply line is interposed between the USB power supply 8 and the printing unit 3, supplying power from the USB power supply 8 to the printing unit 3. In this case, the power storage devices C1 and C2 are in a state in which the power storage devices C1 and C2 are not connected to the "power supply line" (hereinafter referred to as an "unconnected state"). Therefore, the power storage devices C1 and C2 are in an open state in the first mode.

The second mode will be described with reference to FIG. 4. In the second mode, the power from the USB power supply 8 that is supplemented by the power from the power storage devices C1 and C2 (hereinafter referred to as "supplementary power") is supplied to the printing unit 3 (refer to arrow A2). In the second mode, the switch SW1 turns on the connection of the wirings L10 and L13, and the switch SW3 turns on the connection of the wirings L5 and L7. Also, in the second mode, the switch SW2 turns off the connection of the wirings VBUS and L8. As a result, the port 34 and the printing unit 3 are connected via the wirings VBUS, L5, and L7, the power storage devices C1 and C2, and the wirings L10 and L13. Therefore, in the second mode, the wirings VBUS, L5, L7, L10, and L13 function as "power supply lines". In this case, the power storage devices C1 and C2 are in a state in which the power storage devices C1 and C2 are connected in series to the power supply lines (hereinafter referred to as the "first connection state").

The third mode will be described with reference to FIG. 5. In the third mode, the power storage devices C1 and C2 are charged with power from the USB power supply 8 (refer to arrow A4). In the third mode, the switch SW2 turns on the connection of the wirings VBUS and L8. The switch SW1 turns off the connection of the wirings L1, L10, and L13. Also, the switch SW3 connects the wirings L6 and L7. In this case, the port 34 and the ground GND are connected via the wirings VBUS and L8, the charging IC 32, the wiring L10, the power storage devices C1 and C2, and the wirings L7 and L6. Therefore, the power storage devices C1 and C2 are charged with power from the USB power supply 8. Note that the wirings such as the VBUS and L1 through L13 do not function as "power supply lines" because power is not supplied to the printing unit 3. Therefore, the power storage devices C1 and C2 are not connected to the power supply line, but are in a state connected between the USB power supply 8 and the ground GND (hereinafter also referred to as a "second connection state").

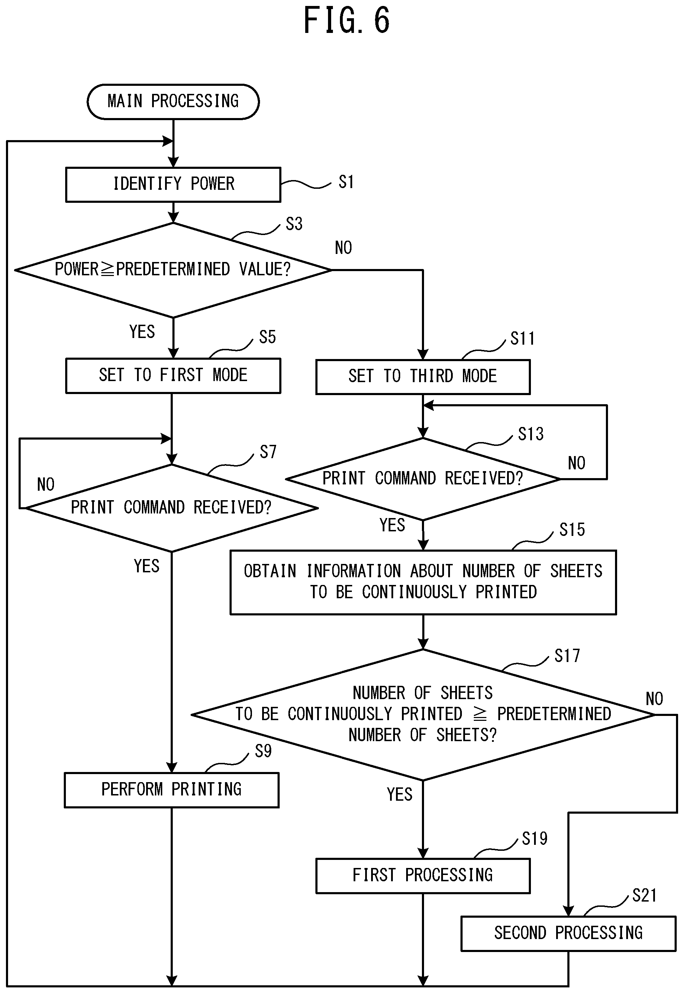

Main processing will be described with reference to FIG. 6. The user connects the USB power supply 8 to the port 34 of the printer 1. The PDIC 31 negotiates with the USB power supply 8. By performing the negotiation, the power supplied from the USB power supply 8 is determined. The PDIC 31 initiates the supply of power from the USB power supply 8. As a result, the digital circuit 6 is activated. The CPU 21 reads a program from the ROM 22 to perform the main processing.

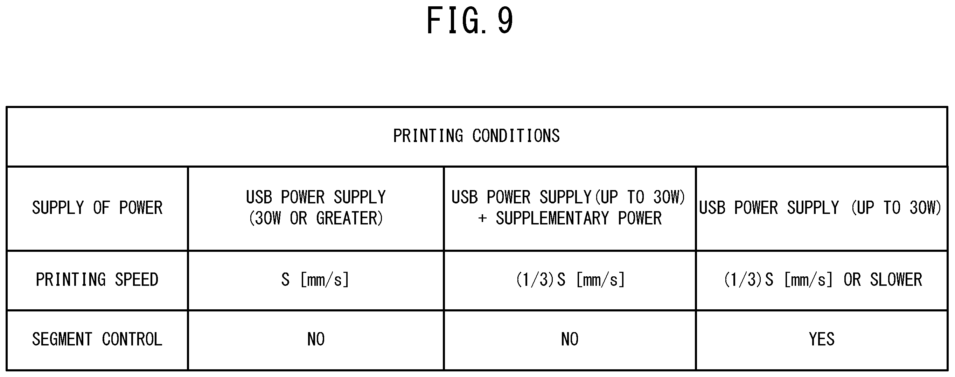

When performing the main processing, the CPU 21 identifies the power from the USB power supply 8 (S1). For example, the CPU 21 receives power information from the PDIC 31. The CPU 21 then determines whether or not the power from the USB power supply 8 is at or above a predetermined value (S3). Here, the predetermined value is, for example, 30W (refer to FIG. 9). In a case where power of 30W or more is supplied, the printer 1 is capable of printing at a maximum speed S, even though printing conditions under a heavy load such as continuous printing, and without the need for segment control, for example. The maximum speed S (refer to FIG. 9) refers to the fastest achievable printing speed of the printing by printer 1, for example. Segment control is a method of printing whereby, when forming a single line of an image, the single line is divided up and printed over a plurality of times.

Based on determining that the power from the USB power supply 8 is at or above a predetermined value (yes at S3), the CPU 21 sets the power supply circuit 100A to the first mode (S5). As a result, power from the USB power supply 8 is supplied to the printing unit 3. The CPU 21 then determines whether a print command is received (S7). Based on determining that a print command has not been received (no at S7), the CPU 21 returns the processing and waits to receive a print command.

On the other hand, based on determining that a print command has been received (yes at S7), the CPU 21 prints onto the medium with the printing unit 3 based on the print command (S9). In this case, the printing unit 3 performs printing at the maximum speed S [mm/s] and without segment control, based on the power of 30W or more (refer to FIG. 9). The CPU 21 then returns the processing to S1.

Meanwhile, based on determining that the power from the USB power supply 8 is below the predetermined value (no at S3), the CPU 21 sets the power supply circuit 100A to the third mode (S11). In this case, there is a possibility that the power required for printing is insufficient, so the CPU 21 charges the power storage devices C1 and C2 in preparation for the print command.

The CPU 21 determines whether a print command has received (S13). Based on determining that a print command has not received (no at S13), the CPU 21 returns the processing and waits to receive a print command.

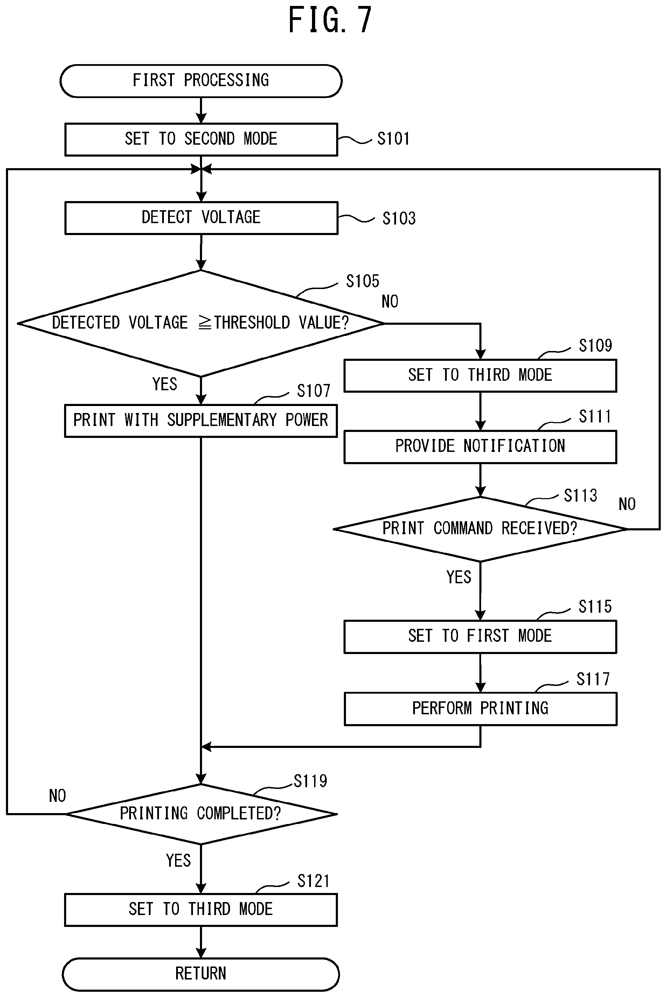

On the other hand, based on determining that a print command has been received (yes at S13), the CPU 21 obtains information on the number of sheets to be continuously printed, in a case where printing is to be performed continuously, based on the print command (S15). The CPU 21 determines whether or not the number of sheets to be continuously printed exceeds a predetermined number (S17). The number of sheets to be continuously printed is information indicating the printing load on the printing unit 3 during printing. The predetermined number should be set appropriately according to the specifications of the printer 1. The CPU 21 contributes to identifying whether the printing load is heavy or light by comparing the number of sheets to be continuously printed with the predetermined number of sheets. Based on determining that the number of sheets to be continuously printed is equal to or greater than the predetermined number (yes at S17), since a situation that the printing load is heavy is assumed, the CPU 21 performs first processing (refer to FIG. 7) (S19).

In a case where the first processing (refer to FIG. 7) is performed, the CPU 21 sets the power supply circuit 100A from the third mode to the second mode (S101). That is, based on determining that the CPU 21 receives a print command to perform printing onto the medium with the printing unit 3 (refer to yes at S13 in FIG. 6) while the power supply circuit 100A is set to the third mode (refer to S11 in FIG. 6), the CPU 21 sets the power supply circuit 100A from the third mode to the second mode. As a result, the power supply circuit 100A is able to supply supplementary power to the printing unit 3.

With the power supply circuit 100A set to the second mode, the CPU 21 detects the voltage being supplied to the printing unit 3 (S103). In this case, the CPU 21 detects the voltage detected by the voltage detection unit 35. The CPU 21 determines whether or not the voltage detected by the voltage detection unit 35 is equal to or greater than a threshold value (S105). Note that the threshold value should be appropriately set according to the specifications of the printer 1.

Based on determining that the detected voltage is above the threshold value (yes at S105), the CPU 21 keeps the power supply circuit 100A set in the second mode and performs printing on the medium with the printing unit 3 based on the supplementary power (S107). In this case, the printing unit 3 performs printing at, for example, one-third of the maximum speed S and without segment control (refer to FIG. 9). Therefore, under a circumstance where power of less than 30W is insufficient, the printing unit 3 can continue printing using the supplementary power. The CPU 21 moves the processing on to S119.

On the other hand, based on determining that the detected voltage is below the threshold value (no at S105), the CPU 21 sets the power supply circuit 100A to the third mode without performing printing on the medium with the printing unit 3 (S109). Because the power required by the printing unit 3 is insufficient even with the supplementary power, the CPU 21 charges the power storage devices C1 and C2 in preparation for the next print command.

The CPU 21 provides a notification in a case where the power supply circuit 100A is set to the third mode (S111). The CPU 21, displays a message such as "Please wait 5 minutes before printing" on a display unit, not shown in the drawings, for example. This allows the user to be aware of the waiting time for printing. Note that the CPU 21 may change the displayed waiting time according to the charging status of power storage devices C1 and C2.

The CPU 21 determines whether a command to forcibly perform printing with the printing unit 3 has received (S113). The command is input to the printer 1 by the user, for example. Based on determining that a command to forcibly perform printing by the printing unit 3 has not received (no at S113), the CPU 21 does not perform printing and returns the processing to S103.

Based on determining that a command to forcibly perform printing with the printing unit 3 has been received (yes at S113), the CPU 21 sets the power supply circuit 100A from the third mode to the first mode (S115). In a case where the power supply circuit 100A set to the first mode, the CPU 21 performs printing on the medium with the printing unit 3 (S117). The printing unit 3 performs printing at a speed equal to or less than one-third of the maximum speed S, and with segment control enabled (refer to FIG. 9). Therefore, the user can forcibly perform printing even under a circumstance where power is insufficient. The CPU 21 then moves the processing on to S119.

The CPU 21 determines whether or not printing on the medium by the printing unit 3 has been completed (S119). Based on determining that the printing on the medium by the printing unit 3 has not been completed (no at S119), such as during continuous printing, the CPU 21 returns to the processing to S103. Accordingly, the CPU 21 can continuously perform printing while verifying the voltage supplied to the printing unit 3 in the processing at S103 and S105.

Based on determining that printing on the medium by the printing unit 3 has been completed (yes at S119), the CPU 21 sets the power supply circuit 100A to the third mode (S121). The CPU 21 charges the power storage devices C1 and C2 in preparation for the next print command. The CPU 21 then returns the processing to the main processing.

Upon returning to the main processing, the CPU 21 returns the processing to S1.

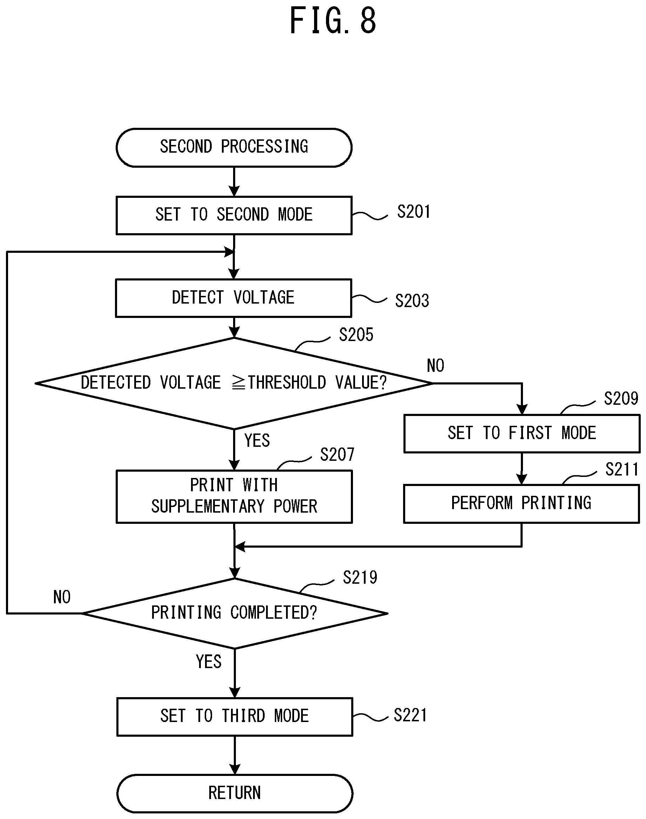

On the other hand, in the main processing, based on determining that the number of sheets to be continuously printed is less than the predetermined number (no at S17), the CPU 21 performs second processing (refer to FIG. 8) (S21). Under a condition where the number of sheets to be continuously printed is less than the predetermined number, there is a possibility that the printing load on the printing unit 3 is light. For this reason, although power may be insufficient, the CPU 21 causes the printing unit 3 to perform printing in the second processing (refer to FIG. 8).

Here, the processing at S201 to S207, S219, and S221 of the second processing (refer to FIG. 8) is similar to the processing at S101 to S107, S119, and S121 of the first processing (refer to FIG. 7). Therefore, in the following description, the description of S201 to S207, S219, and S221 will be simplified and focus on the parts that are different. Note that in the first processing (refer to FIG. 7), a notification is given to the user (S111), whereas in the second processing (refer to FIG. 8), printing is performed without providing notification (S211), which is different.

Upon performing the second processing (refer to FIG. 8), the CPU 21 performs the processing at S201 through S207 and S219. As with the first processing, the CPU 21 causes the printing unit 3 to perform printing continuously based on the supplementary power (S207).

On the other hand, based on determining that the voltage detected in the processing at S203 is below the threshold value (no at S205), the CPU 21 sets the power supply circuit 100A from the second mode to the first mode (S209). In a case where the power supply circuit 100A is set to the first mode, the CPU 21 causes the printing unit 3 to print on the medium (S211). In this case, there is a possibility that the power may be insufficient, so the CPU 21 performs printing at a speed that is one-third or less of the maximum speed S and with segment control enabled, based on the power of the USB power supply 8 (refer to FIG. 9). As a result, the CPU 21 contributes to continuing printing under a circumstance where the power is insufficient.

Based on determining that the printing is completed (yes at S219), the CPU 21 sets the power supply circuit 100A to the third mode (S221). The CPU 21 charges the power storage devices C1 and C2 in preparation for the next print command. The CPU 21 then returns the processing to the main processing.

Upon returning to the main processing, the CPU 21 returns the processing to S1.

As described above, the power supply circuit 100A includes the power supply line and the storage devices C1 and C2. The power supply line supplies power from the USB power supply 8 to the printing unit 3. The power storage devices C1 and C2 charge and discharge a predetermined amount of power. The CPU 21 connects the power storage devices C1 and C2 in series to the USB power supply 8 in the power supply line.

Because the power storage devices C1 and C2 are connected in series to the USB power supply 8, the printer 1 supplies, to the printing unit 3, power obtained by supplementing the power from the USB power supply 8 with the power from the power storage devices C1 and C2. Therefore, the printer 1 contributes to reducing the likelihood of printing being restricted under a circumstance where the power from the USB power supply 8 is insufficient.

The CPU 21 disconnects the power storage devices C1 and C2 from the power supply line. The CPU 21 connects the power storage devices C1 and C2 between the USB power supply 8 and the ground GND. The CPU 21 sets the mode of the power supply circuit 100A to one mode among the first mode, the second mode, or the third mode. The first mode is a mode in which power from USB power supply 8 is supplied to the printing unit 3. The second mode is a mode where supplementary power, which is the power from the USB power supply 8 supplemented with the power storage devices C1 and C2, is supplied to the printing unit 3. The third mode is a mode for charging the power storage devices C1 and C2. The printer 1 contributes to performing printing using the supplementary power under a circumstance where the power supplied from the USB power supply 8 is insufficient. Additionally, the printer 1 contributes to performing printing only with the power from the USB power supply 8 under a circumstance where the power is sufficiently large, for example. Under a circumstance where the power from the USB power supply 8 is low, the printer 1 contributes to preparing for printing by charging the power storage devices C1 and C2. In other words, the printer 1 contributes to setting one mode among the first mode to the third mode, according to the power of the USB power supply 8.

Based on determining that the power from the USB power supply 8 is equal to or greater than the predetermined value, the CPU 21 sets the power supply circuit 100A to the first mode. Based on determining that the power from the USB power supply 8 is less than the predetermined value, the CPU 21 sets the power supply circuit 100A to the third mode. When the power from the USB power supply 8 is sufficiently large, for example, the printer 1 contributes to performing printing with power supplied only by the USB power supply 8. Based on determining that the power from the USB power supply 8 is less than the predetermined value, the printer 1 contributes to preparing for printing by charging the power storage devices C1 and C2.

Based on determining that a print command to perform printing on the medium with the printing unit 3 had rec received, while the power supply circuit 100A is set to the third mode, the CPU 21 switches the power supply circuit 100A from the third mode to the second mode. In a case where the power supply circuit 100A set to the second mode, the CPU 21 detects the voltage supplied to the printing unit 3. Based on determining that the detected voltage is equal to or above the threshold value, the CPU 21 keeps the power supply circuit 100A in the second mode and performs printing on the medium with the printing unit 3 based on the supplementary power. Based on determining that the detected voltage is below the threshold value, the CPU 21 sets the power supply circuit 100A to the third mode without performing printing on the medium with the printing unit 3. The printer 1 contributes to performing printing with the printing unit 3 based on the supplementary power, under a circumstance where the power from the USB power supply 8 is insufficient. Furthermore, under a circumstance where the supplementary power is insufficient based on the relationship between the detected voltage and the threshold value, the printer 1 contributes to performing charging of the power storage devices C1 and C2 to compensate for the power deficiency.

When the power supply circuit 100A is set to the third mode, the CPU 21 provides notification. The printer 1 contributes to help the user become aware of the need to wait until the power storage devices C1 and C2 are sufficiently charged, for example, before starting printing.

The CPU 21 receives a command to forcibly perform printing with the printing unit 3. Based on determining that a command has received, the CPU 21 sets the power supply circuit 100A from the third mode to the first mode. With the power supply circuit 100A set to the first mode, the CPU 21 performs printing on the medium with the printing unit 3. The printer 1 contributes to performing printing at a reduced printing speed, for example, using power from the USB power supply 8.

The print command includes information on the number of sheets to be continuously printed under conditions where printing is performed continuously. Based on determining that the number of sheets to be continuously printed is equal to or greater than the predetermined value, the CPU 21 sets the power supply circuit 100A to the third mode. When the printing load is heavy, such as a condition where the number of sheets to be continuously printed is large, the printer 1 charges the power storage devices C1 and C2 without performing printing. Thus, the printer 1 contributes to avoiding operation under overload conditions.

Based on determining that a print command to perform printing on the medium with the printing unit 3 has received, while the power supply circuit 100A is set to the third mode, the CPU 21 sets the power supply circuit 100A from the third mode to the second mode. In a case where the power supply circuit 100A set to the second mode, the CPU 21 detects the voltage supplied to the printing unit 3. Based on determining that the detected voltage is greater than or equal to the threshold value, the CPU 21 keeps the power supply circuit 100A in the second mode and performs printing on the medium with the printing unit 3 based on the supplementary power. Based on determining that the detected voltage is below the threshold value, the CPU 21 sets the mode from the second mode to the first mode. In a case where the power supply circuit 100A set to the first mode, the CPU 21 performs printing on the medium with the printing unit 3. Under a circumstance where the power from the USB power supply 8 is insufficient, the printer 1 contributes to performing printing with the printing unit 3 based on supplementary power. Furthermore, under a circumstance where the supplementary power is insufficient based on the relationship between the detected voltage and the threshold value, the printer 1 contributes to performing printing on the medium by reducing the printing speed, for example.

The print command includes information on the number of sheets to be continuously printed in a case where printing is performed continuously. Based on determining that the number of sheets to be continuously printed is less than the predetermined number, the CPU 21 performs printing on the medium with the printing unit 3 while the power supply circuit 100A is set to the first mode. The printer 1 contributes to performing printing at a reduced printing speed or the like under a circumstance where the printing load is light, such as a case where the number of sheets to be continuously printed is small.

The CPU 21 sets the power supply circuit 100A to the third mode after printing on the medium by the printing unit 3 is completed. The printer 1 also contributes to resuming charging of the power storage devices C1 and C2 after printing on the medium is completed.

The power storage devices C1 and C2 are in an open state in the first mode. In the first mode, the printer 1 does not charge or discharge the power storage devices C1 and C2. Therefore, the printer 1 contributes to reducing the number of charge and discharge cycles of the power storage devices C1 and C2. Therefore, the printer 1 contributes to suppressing degradation of the power storage devices C1 and C2.

The power storage devices C1 and C2 are electric double-layer capacitors. By using electrical double-layer capacitors, the printer 1 contributes to achieving rapid charging.

The power supply circuit 100A is powered by the USB power supply 8. Under a circumstance where the power from the USB power supply 8 is insufficient, the printer 1 contributes to reducing the likelihood of printing being restricted.

In the above-described embodiment, the USB power supply 8 is an example of the "power supply" of the present invention. The CPU 21 is an example of the "controller" of the present invention. The processing at S5, S11, S101, S109, S121, S201, S209, and S221 performed by the CPU 21 are examples of the "setting processing" of the present invention. The processing at S101 and S201 performed by CPU 21 is an example of the "connecting processing" of the present invention. The processing at S5, S115, and S209 performed by the CPU 21 is an example of the "disconnecting processing" of the present invention. The processing performed by the CPU 21 at S11, S109, S121, and S221 is an example of the "grounding processing" of the present invention.

The processing at S5 performed by the CPU 21 is an example of the "first setting processing" of the present invention. The processing at S11 performed by the CPU 21 is an example of the "second setting processing" of the present invention. The processing at S101 and S201 performed by the CPU 21 is an example of the "third setting processing" of the present invention. The processing at S103 and S203 performed by the CPU 21 is an example of the "detection processing" of the present invention. The processing at S107 and S207 performed by the CPU 21 is an example of the "first printing processing" of the present invention. The processing at S109 performed by the CPU 21 is an example of the "fourth setting processing" of the present invention. The processing at S111 performed by the CPU 21 is an example of the "notification processing" of the present invention. The processing at S113 performed by the CPU 21 is an example of the "receiving processing" of the present invention. The processing at S115 performed by the CPU 21 is an example of the "fifth setting processing" of the present invention. The processing at S209 performed by the CPU 21 is an example of the "sixth setting processing" of the present invention. The processing at S117 and S211 performed by the CPU 21 is an example of the "second printing processing" of the present invention. The processing at S121 and S221 performed by the CPU 21 is an example of the "seventh setting processing" of the present invention.

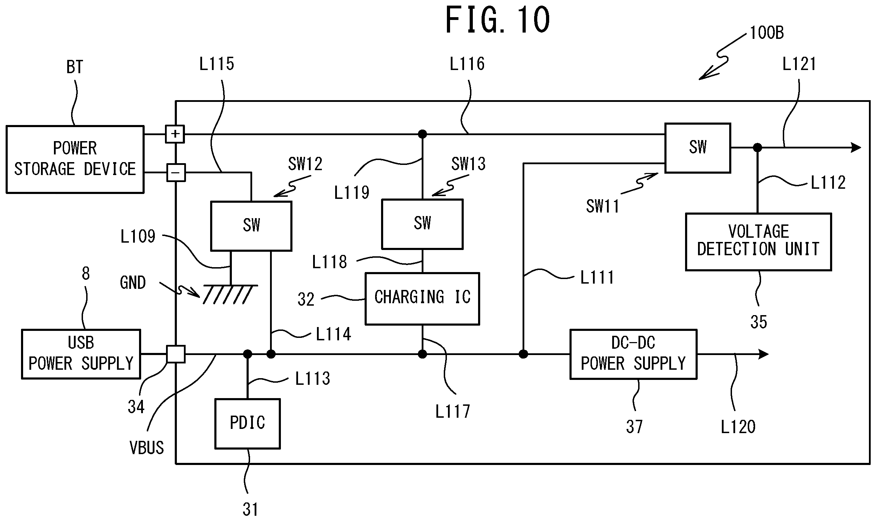

A power supply circuit 100B according to a modified example will now be described with reference to FIG. 10 to FIG. 13. In the power supply circuit 100A of the above-described embodiment, the power storage devices C1 and C2 were electric double-layer capacitors. In contrast, the power supply circuit 100B of the modified example uses a lithium-ion battery as a power storage device BT. In the following description, members that are the same as the members in the power supply circuit 100A will be denoted by the same reference characters, and detailed descriptions thereof will be omitted. The description will focus on those parts that are different.

The power supply circuit 100B includes the port 34, the PDIC 31, the charging IC 32, the voltage detection unit 35, the DC-DC power supply 37, switches SW11 to SW13, as well as wirings VBUS, L109, and L111 to L121.

The port 34 is connected to the DC-DC power supply 37 via the wiring VBUS. The PDIC 31 is connected to the port 34 via wires VBUS and L113. The switch SW11 is connected to the port 34 via the wirings VBUS and L111. Also, the switch SW11 is connected to the printing unit 3 via the wiring L121. The switch SW11 switches the connection of the wirings L111, L116 and L121.

The switch SW12 is connected to the port 34 via the wirings VBUS and L114. Also, the switch SW12 is connected to the ground GND via the wiring L109. The switch SW12 is also connected to a negative electrode of the power storage device BT via the wiring L115. A positive electrode of the power storage device BT is connected to the switch SW11 via the wiring L116. The switch SW12 switches the connection of the wirings L114, L115, and L109.

The charging IC 32 is connected to the port 34 via the wirings L117 and VBUS. Also, the charging IC 32 is connected to switch SW13 via the wiring L118. Furthermore, the switch SW13 is connected to the positive terminal of the power storage device BT via the wirings L119 and L116. The voltage detection unit 35 is connected to the printing unit 3 via the wirings L112 and L121. The switch SW13 switches the connection of the wirings L118 and L119.

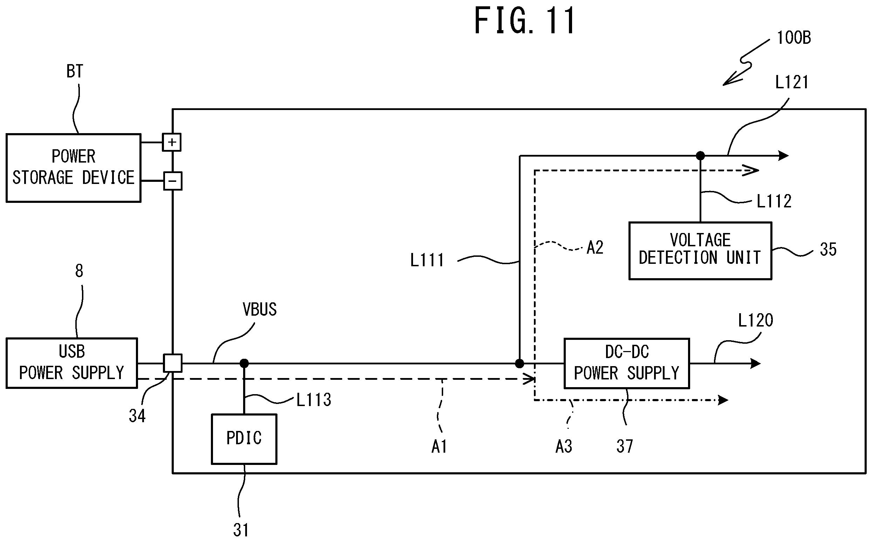

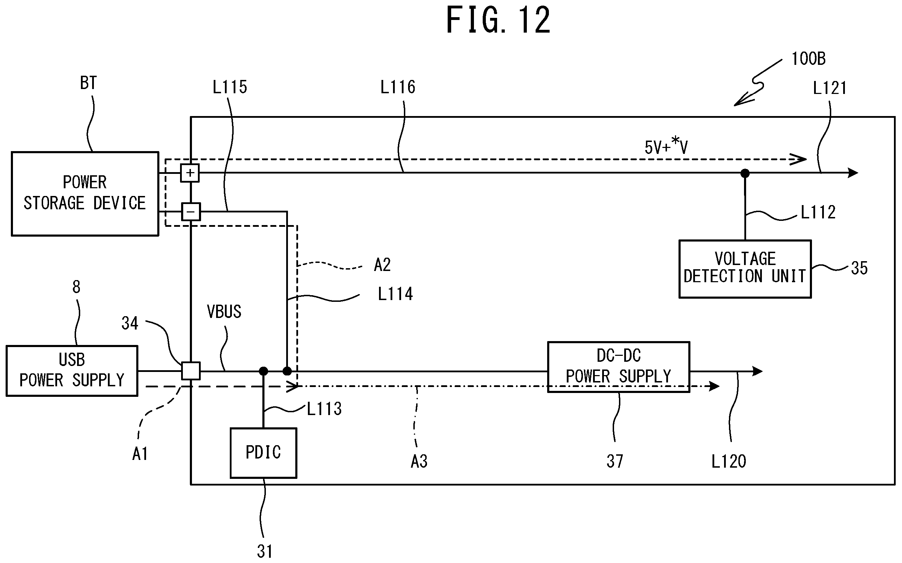

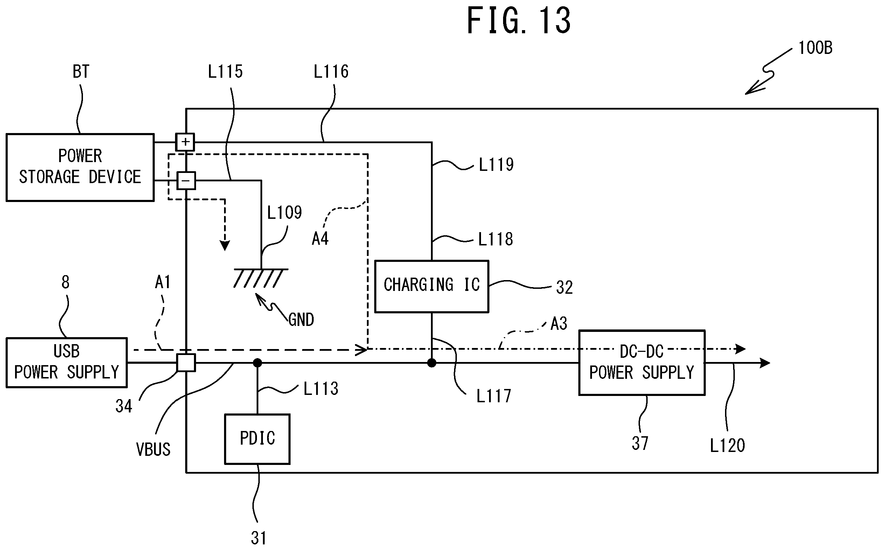

Similar to the power supply circuit 100A, the power supply circuit 100B can be set to one mode among a first mode (refer to FIG. 11), a second mode (refer to FIG. 12), and a third mode (refer to FIG. 13). The switching between the first mode and the third mode is achieved by changing the states of the switches SW11 to SW13. The CPU 21 controls the switches SW11 to SW13.

The first mode will be described with reference to FIG. 11. In the first mode, the power from the USB power supply 8 is supplied to the printing unit 3 (refer to arrow A2). In the first mode, the switch SW11 turns on the connection of the wirings L111 and L121. The switch SW12 turns off the connection of the wirings L114, L115, and L109. The switch SW13 turns off the connection of the wirings L118 and L119. As a result, the port 34 and the printing unit 3 are connected via the wirings VBUS, L111, and L121. Therefore, the power supply circuit 100B contributes to supplying power from the USB power supply 8 to the printing unit 3. Thus, in the first mode, the wirings VBUS, L111, and L121 function as "power supply lines". In this case, the power storage device BT is in a state where the power storage device BT is not connected to the power supply line (hereinafter referred to as an "unconnected state"). Thus, the power storage device BT is in an open state in the first mode.

The second mode will be now described with reference to FIG. 12. In the second mode, the power from the USB power supply 8 that is supplemented by the power from the power storage device BT (hereinafter referred to as "supplementary power") is supplied to the printing unit 3 (refer to arrow A2). In the second mode, the switch SW11 turns on the connection of the wirings L116 and L121. The switch SW12 turns on the connection of the wirings L114 and L115. The switch SW13 turns off the connection of the wirings L118 and L119. As a result, the port 34 and the printing unit 3 are connected via the wirings VBUS, L114, and L115, the power storage device BT, and the wirings L116 and L121. Therefore, in the second mode, the wirings VBUS, L114 to L116, and L121 function as "power supply lines". In this case, the power storage device BT is in a state in which the power storage device BT is connected in series to the power supply line (hereinafter referred to as the "first connection state").

The third mode will now be described with reference to FIG. 13. In the third mode, the power storage device BT is charged by the power from the USB power supply 8 (refer to arrow A4). In the third mode, the switch SW11 turns off the connection of the wirings L111, L116, and L121. The switch SW13 turns on the connection of the wirings L118 and L119. The switch SW12 turns on the connection of the wirings L115 and L109. Accordingly, the port 34 and the ground GND are connected via the wirings VBUS and L117, the charging IC 32, the wirings L118, L119, and L116, the power storage device BT, and the wirings L115 and L109. As a result, the power storage device BT is charged by the power from the USB power supply 8. The wiring VBUS and the like does not function as a power supply line because power is not supplied to the printing unit 3. Therefore, the power storage device BT is not connected to the power supply line, but is connected between the USB power supply 8 and the ground GND (hereinafter referred to as the "second connection state").

With the above-described configuration, the printer 1 can realize the functions of the power supply circuit 100A by using a lithium-ion battery. As a result, the CPU 21 can perform each step in the above-described embodiment using the power supply circuit 100B. The printer 1 contributes to compensating for power by using the lithium-ion battery for long period of time.

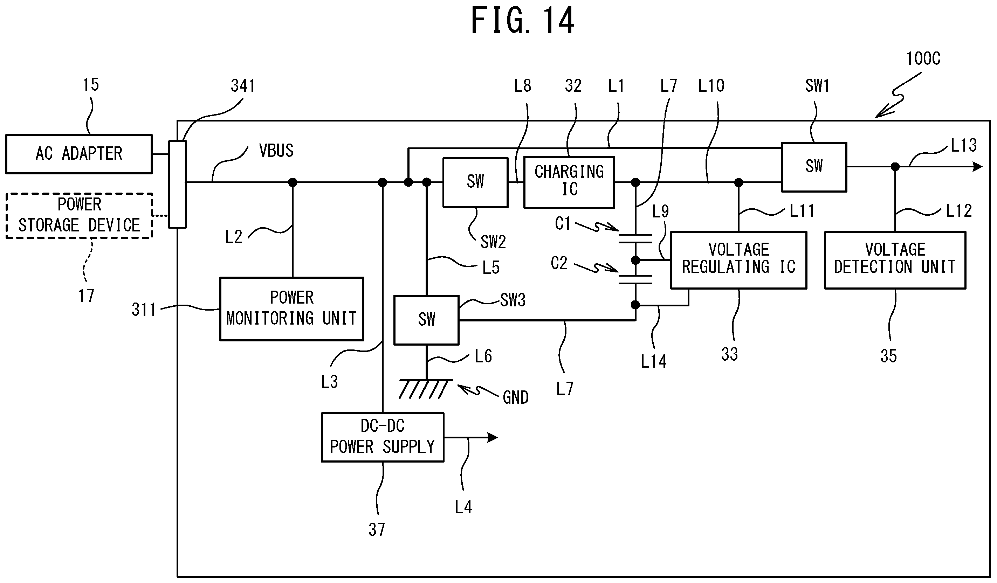

The power supply circuit 100C according to a modified example will be described with reference to FIG. 14 to FIG. 17. In the power supply circuit 100A of the above-described embodiment, power from the USB power supply 8 was supplied. In contrast, the power supply circuit 100C of the modified example differs in that the power supply circuit 100C is powered by an AC adapter 15 or a battery 17. Also, in the following description, members that are the same as the members in the power supply circuit 100A will be denoted by the same reference characters, and detailed descriptions thereof will be omitted. The description will focus on those parts that are different.

As shown in FIG. 14, the power supply circuit 100C includes a port 341 and a power monitoring unit 311 instead of the port 34 and the PDIC 31 of the power supply circuit 100A.

The port 341 includes a connector for the AC adapter and a connector terminal for the battery 17. Either the AC adapter 15 or the battery 17 is connected to the port 341. The battery 17 is stored inside the printer 1, for example. The power that can be supplied by the AC adapter 15 or the battery 17 may be the same that of the above-described embodiment or different therefrom.

The power monitoring unit 311 monitors the power output from the AC adapter 15 or the battery 17, for example. The power monitoring unit 311 is an electronic device, for example. The power monitoring unit 311 transmits the power monitoring results to the CPU 21. Note that the power monitoring unit 311 may monitor the current and power output from the AC adapter 15 and transmit the information to the CPU 21.

Because the power supply circuit 100C has the same configuration except for the port 341 and the power monitoring unit 311, the CPU 21 can perform the same control as described in the above-described embodiment. That is, the CPU 21 is capable of performing the main processing, the first processing, the second processing, and the like. Note that in the main processing, the CPU 21 identifies the power of the AC adapter 15 or the battery 17 monitored by the power monitoring unit 311 (S1), and compares the monitoring result of the power monitoring unit 311 with a predetermined value (S3). Furthermore, in each processing, the printing conditions shown in FIG. 9 may be used.

Similarly, the CPU 21 is capable of setting the mode of the power supply circuit 100C to one mode among the first mode to the third mode. In the following description, a situation that the AC adapter 15 is connected to the port 341 is assumed.

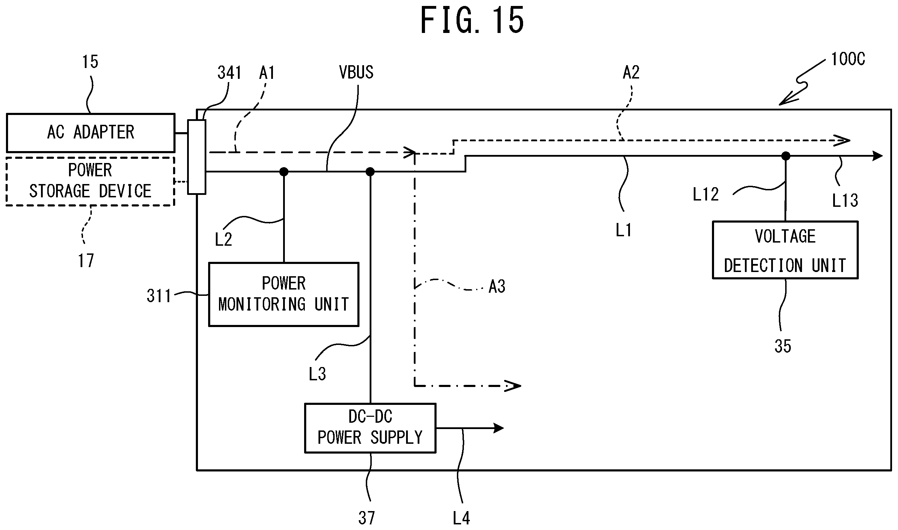

As shown in FIG. 15, in the first mode, the power storage devices C1 and C2 are in an "unconnected state" with respect to the AC adapter 15. In the first mode, the printing unit 3 is driven only by power from the AC adapter 15.

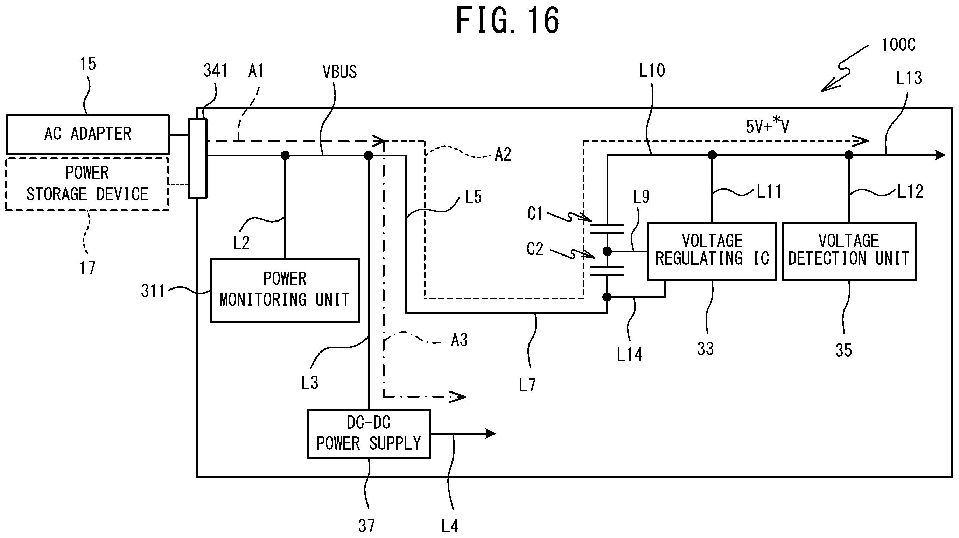

As shown in FIG. 16, in the second mode, the power storage devices C1 and C2 are connected in series to the AC adapter 15. In other words, the power storage devices C1 and C2 are in a "first connected state". The printing unit 3 is driven by supplementary power in which the power from the AC adapter 15 is supplemented by the power from power storage devices C1 and C2.

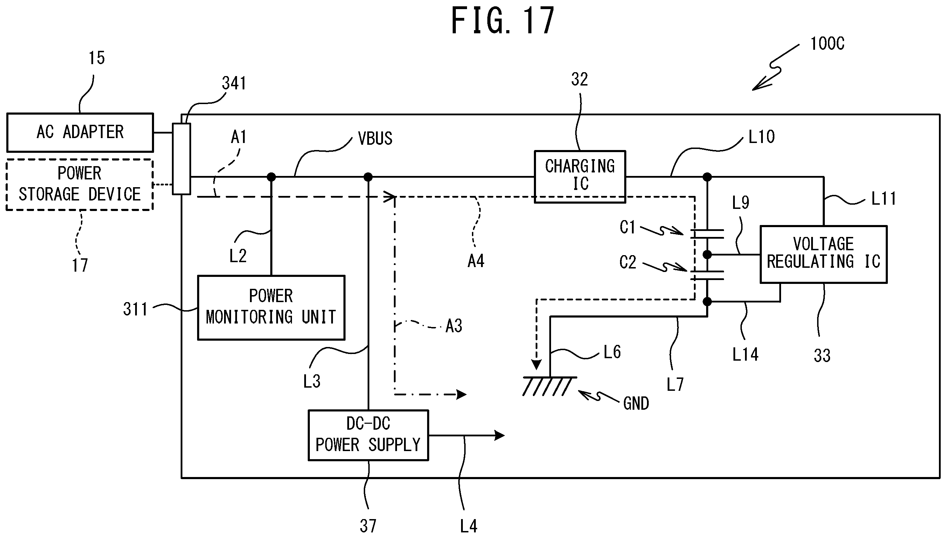

As shown in FIG. 17, in the third mode, the power storage devices C1 and C2 are connected between the AC adapter 15 and the ground GND. In other words, the power storage devices C1 and C2 are in a "second connected state". The power from the AC adapter 15 charges the power storage devices C1 and C2.

As described above, the printer 1 is driven by either the AC adapter 15 or the battery 17. The power supply circuit 100C contributes to achieving effects similar to those of the power supply circuit 100A. For example, the printer 1 contributes to reducing the likelihood of printing being restricted under a circumstance where the power from the AC adapter 15 or the battery 17 is insufficient.

In the above-described modified example, the AC adapter 15 is an example of the "power supply" of the present invention. The battery 17 is an example of the "power supply" of the present invention.

Note that the power supply circuit 100C may be driven either by only the AC adapter 15 or only the battery 17. In this case, the port 341 only needs to have either the connector for the AC adapter or the connector terminal for the battery 17.

The present invention can be further modified from the above-described embodiment. Note that the techniques disclosed in the above-described embodiment, the above-described modified example, and the following modified example can be combined insofar as no contradictions arise. The above-described printer 1 performs printing on thermal cut sheet paper, but it is not limited to this. For example, the printer 1 may be a thermal transfer-type printer or the printer 1 may be an inkjet-type printer.

In the above-described embodiment, the printer 1 was driven by the USB power supply 8, but it is not limited to this. For example, the printer 1 may use an external battery or the like instead of the USB power supply 8. In other words, the printer 1 may be driven by the power of an external battery and the power storage devices C1, C2, and BT.

In this case, instead of charging the power storage devices C1, C2, and BT with power from the USB power supply 8, the power storage devices C1, C2, and BT may be charged using power from an external battery or the like.

The power supply circuit 100A in the above-described embodiment was implemented with the configuration shown in FIG. 2, but it is not limited to this. For example, the configuration of the power supply circuit 100A may be modified as appropriate, as long as the functions (first mode, second mode, and third mode) can be achieved. The same applies to the power supply circuit 100B shown in FIG. 10.

In the above-described embodiment, the power supply circuit 100A had the power storage devices C1 and C2 connected in series, but it is not limited to this. For example, when a large amount of power is desired, the power storage devices C1 and C2 may be connected in parallel. As a result, the power supply circuit 100A can further increase the supplementary power.

In the above-described embodiment, there were two of the power storage devices C1 and C2, but the invention is not limited to this. The number can be changed as appropriate. The capacitance of the power storage devices C1 and C2 may be modified as appropriate.

The power supply circuit 100B in the modified example used a single power storage device BT, but it is not limited to this. For example, the power supply circuit 100B may connect a plurality of power storage devices BT in series or in parallel. In a case where objective is to supply a higher voltage, the power supply circuit 100B may connect the power storage devices BT in series. In a case where objective is to supply greater power, the power supply circuit 100B may connect the power storage devices BT in parallel.

In the first processing and the second processing of the above-described embodiment, the power supply circuit 100A was set to the first mode at S115 and S209, and printing was performed by the processing at S111 and S211, but the invention is not limited to this. For example, printing may be performed while the power supply circuit 100A is still in the second mode, without performing the processing at S115 and S209.

In the above-described embodiment, printing based on the printing conditions shown in FIG. 9 was performed, but the invention is not limited to this. The printing conditions may be set as appropriate according to the specifications of the printer 1 and the printing load. For example, under a circumstance where less than 30W of power is supplied only from the USB power supply 8, the printing unit 3 may perform printing at one-third of the maximum speed S and with segment control enabled.

Note that, in place of the CPU 21, the PDIC 31, a microcomputer, an ASIC, a field programmable gate array (FPGA), or the like may be used as the processor. The main processing may be processed in a distributed manner by a plurality of processors. The digital circuit 6 may include another non-transitory storage medium, such as flash memory or an HDD or the like, for example. The non-transitory storage medium may be a storage medium capable of saving information, regardless of the period of storage of the information. The non-transitory storage medium need not necessarily include a temporary storage medium (a transmission signal, for example).

Each of the various programs may be downloaded (that is, may be transmitted as transmission signals) from a server connected to a network (not shown in the drawings), for example, and may be stored in a memory such as flash memory or an HDD or the like. In this case, each of the various programs may be stored in a non-transitory storage medium, such as an HDD or the like, included in the server.

## Claims

1. A printer adapted to perform printing on a medium, the printer comprising:
a printing unit (3) disposed inside the printer;
a power supply circuit (100A, 100B, 100C) disposed inside the printer, and including a power supply line and a power storage device, the power supply line is adapted to supply power from a power supply (8, 15, 17) to the printing unit (3), and the power storage device is adapted to charge and discharge a predetermined power; and
a controller (21) adapted to perform:
connecting processing to connect the power storage device in series with the power supply (8, 15, 17) in the power supply line, by controlling the power supply circuit (100A, 100B, 100C).

2. The printer according to claim 1, wherein
the controller (21) is further adapted to perform:
disconnecting processing to disconnect the power storage device from the power supply line;
grounding processing to connect the power storage device between the power supply (8, 15, 17) and a ground; and
setting processing to set a mode of the power supply circuit (100A, 100B, 100C) to one mode among a first mode, a second mode, and a third mode, the first mode being a mode to supply power from the power supply (8, 15, 17) to the printer unit (3) by performing the disconnecting processing, the second mode being a mode to supply, to the printing unit (3), supplementary power in which the power from the power supply (8, 15, 17) is supplemented by the power from the power storage device by performing the connecting processing, and the third mode being a mode to charge the power storage device by performing the grounding processing.

3. The printer according to claim 2, wherein
the controller (21) is adapted to perform, in the setting processing:
first setting processing to set the power supply circuit (100A, 100B, 100C) to the first mode based on determining that power from the power supply (8, 15, 17) is equal to or greater than a predetermined value; and
second setting processing to set the power supply circuit (100A, 100B, 100C) to the third mode based on determining that the power from the power supply (8, 15, 17) is less than the predetermined value.

4. The printer according to claim 3, wherein
the controller (21) is adapted to perform, in the setting processing:
third setting processing to set the power supply circuit (100A, 100B, 100C) from the third mode to the second mode based on receiving a print command causing the printing unit (3) to print onto the medium, while the power supply circuit (100A, 100B, 100C) is in a state set to the third mode by the second setting processing;
detection processing to detect a voltage supplied to the printing unit (3) while the power supply circuit (100A, 100B, 100C) is in a state set to the second mode in the third setting processing;
first printing processing to cause, in a state in which the power supply circuit (100A, 100B, 100C) is set to the second mode, the printing unit (3) to perform printing onto the medium based on the supplementary power, based on determining that the voltage detected in the detection processing is equal to or greater than a threshold value; and
fourth setting processing to, based on determining that the voltage detected in the detection processing is less than the threshold value, set the power supply circuit (100A, 100B, 100C) to the third mode without causing the printing unit (3) to perform printing onto the medium.

5. The printer according to claim 4, wherein
the controller (21) is adapted to perform
notification processing to provide notification based on determining that the power supply circuit (100A, 100B, 100C) is set to the third mode in the fourth setting processing.

6. The printer according to claim 4, wherein
the controller (21) is adapted to further perform receiving processing to receive a command to forcibly perform printing by the printing unit (3);
wherein the controller (21) is adapted to perform fifth setting processing to, in the setting process, set the power supply circuit (100A, 100B, 100C) from the third mode set in the fourth setting processing to the first mode, based on determining that the command is received in the receiving processing; and
wherein the controller (21) is adapted to further perform second printing processing to perform printing onto the medium by the printing unit (3) with the power supply circuit (100A, 100B, 100C) set to the first mode in the fifth setting processing.

7. The printer according to claim 4, wherein
the print command includes information about the number of sheets to be continuously printed in a case where printing is to be performed continuously; and
the controller (21) is adapted to perform, in the setting processing,
the fourth setting processing based on determining that the number of sheets to be continuously printed is equal to or greater than a predetermined number of sheets.

8. The printer according to claim 3, wherein
the controller (21) is adapted to perform, in the setting process:
third setting processing to set the power supply circuit (100A, 100B, 100C) from the third mode to the second mode based on determining that a print command causing the printing unit (3) to print onto the medium is received, while the power supply circuit (100A, 100B, 100C) is in a state set to the third mode in the second setting processing;
detection processing to detect a voltage supplied to the printing unit (3) while the power supply circuit (100A, 100B, 100C) is set to the second mode in the third setting processing;
first printing processing to cause, in a state in which the power supply circuit (100A, 100B, 100C) is set to the second mode, the printing unit (3) to perform printing onto the medium based on the supplementary power, based on determining that the voltage detected in the detection processing is equal to or greater than a threshold value;
sixth setting processing to, based on determining that the voltage detected in the detection processing is less than the threshold value, set the power supply circuit (100A, 100B, 100C) from the second mode set in the third setting processing to the first mode; and
second printing processing to perform printing onto the medium by the printing unit (3), while the power supply circuit (100A, 100B, 100C) is in a state set to the first mode in the sixth setting processing.

9. The printer according to claim 8, wherein
the print command includes information about the number of sheets to be continuously printed in a case where printing is to be performed continuously; and
the controller (21) is adapted to perform
the second printing processing based on determining that the number of sheets to be continuously printed is less than a predetermined number of sheets.

10. The printer according to any one of claims 4, 6, 8, or 9, wherein
the controller (21) is adapted to perform, in the setting processing,
seventh setting processing to set the power supply circuit (100A, 100B, 100C) to the third mode based on determining that the printing onto the medium by the printing unit (3) is completed.

11. The printer according to claim 2, wherein
the power storage device is in an open state in the first mode.

12. The printer according to any one of claims 1 to 11, wherein
the power storage device is an electric double-layer capacitor.

13. The printer according to any one of claims 1 to 11, wherein
the power storage device is a lithium-ion battery.

14. The printer according to any one of claims 1 to 13, wherein
the power supply (8, 15, 17) is a USB power supply (8).

15. The printer according to any one of claims 1 to 13, wherein
the power supply (8, 15, 17) is an AC adapter (15) or a battery (17).
